# EUROPEAN PATENT APPLICATION

(11) **EP 1 528 487 A2**
(43) Date of publication of application: **04.05.2005**
(21) Application number: 04292451.4
(22) Date of filing: 15.10.2004
(51) Int. Cl.: G06F 17/50

(54) **Method for improving performance of critical path in field programmable gate arrays**

(30) Priority: 29.10.2003 US 697406
(71) Applicant: Bull HN Information Systems Inc., Billerica, MA 01821-4186 (US)
(72) Inventor: Guenthner, Russell W., Phoenix, AZ 85302 (US); Selway, David W., Phoenix, AZ 85015 (US); Eckard, Clinton B., Glendale, AZ 85310 (US); Ryan, Charles P., Phoenix, AZ 85027 (US); Conway, Eric E., (US)
(74) Representative: Debay, Yves

(57) **Abstract**

A methodology for improving the timing of specific critical paths in a Field Programmable Gate Array (FPGA) implementation of a logic circuit without significantly affecting the timing of other logic paths. The method utilizes logic replication and specific guidelines for placement of the logic gates involved in a critical path to optimize the timing of that critical path. The logic gates involved in a critical path are either replicated and placed, or simply moved, in order to implement the desired logic with nearly the shortest total distance for routing of signals involved in the critical path. The optimization is carried out with relatively little impact on the timing of other paths and is applicable to FPGAs in which the signal delay between any source and gate is relatively independent of the fanout of the source signal to any other loads.

## Description

### FIELD OF THE INVENTION

The present invention relates to Field Programmable Gate Arrays (FPGAs), and a methodology for improving the performance of logic that appears as a critical timing path. More particularly, the invention relates to logic design, logic synthesis, gate array placement algorithms, duplication of logic for improved performance, and iterative approaches for improvement of the implementation and timing of a logic function within an integrated circuit chip, a gate array chip, or a field programmable gate array.

### DESCRIPTION OF THE RELATED ART

In the design of any electronic circuit there are often contentious factors affecting the overall design which determine if the design can be implemented with the desired characteristics. Typically, the amount of logic required to implement a specified logic function and the performance of the logic circuit with regards to timing are two of the most important features of any particular implementation of a design. Sometimes it is found that minimizing the amount of logic will at the same time improve the overall performance of the logic circuit. Sometimes it is found that duplicating certain logic functions in areas of the design where they are most timing critical will improve the performance of the circuit, although this duplication requires added logic. The overall quality and performance of the logic design is affected by many things. The total amount of logic, the number of levels of logic in the critical paths, the routing congestion between logic circuits, the placement of the logic circuits, the loading of signals and other well known factors all have direct effect on the performance of a logic design.

Algorithms for logic optimization, logic placement, logic routing and other steps in the logic implementation process are well known to those skilled in the art and are the frequent subject of writing and discussion. A typical method of evaluating and choosing from the many alternative implementations is to first synthesize a logic design while focusing primarily on minimizing the amount of logic required to implement the desired logic functions. This provides a starting point for analysis. Then, the performance of the logic circuit is evaluated; violations of the required performance parameters are identified, and further optimization is performed in the area of logic which specifically affects the most critical logic paths. Changing the placement of the logic circuits which implement the design is often part of the experimentation that occurs in searching for a better solution. The process of changing the design, evaluating the results, and identifying the areas which still need improvement is repeated until the designer chooses a result.

During the iterative process of making logic changes to improve a critical logic path in a design, there are often possible changes considered which have side effects on other logic paths, which themselves may be critical. As an example, moving a gate to shorten the logic connections in an attempt to improve the performance of one logic path may have the detrimental effect of lengthening the connections involved in another logic path. As a second example, changing the logic to improve delay in one critical logic path, may add loading to signals which increases the delay in another important logic path.

Accordingly there is need for a methodology that more predictably allows optimization of one logic path with less chance of significant impact on the timing of other logic paths.

### SUMMARY OF THE INVENTION

The present invention provides a method for optimizing the logic implementation and layout for a specific logic path in a Field Programmable Gate Array with less effect on other logic paths than methodologies of the prior art and thus to evaluate and find implementations of the overall circuit with better performance.

The technique described is applicable to circuits or Field Programmable Gate Arrays which have a delay characteristic in which the delay from a source gate to any load gate is relatively independent of the fanout to other loads on the same net. That is, for a net which connects a source gate to multiple loads, the delay function for any given load is a function mainly of the distance from the source to that load with the effect of other loads on that delay being relatively small. This includes the effect of both the electrical loading and the electrical distance involved. This characteristic of interconnect and routing is exemplified in the Virtex family of FPGAs from Xilinx. The characteristic of delay as described is relatively unique and is realized in the detailed design of the Xilinx Virtex family. The method and circuitry for achieving this characteristic is not part of this invention, and indeed the details of how it is achieved are not disclosed by Xilinx. The appreciation of this characteristic provides basis for a methodology providing an improved method of logic optimization.

In most implementations of electronic circuits the logic delay from one circuit that is the source of a signal to those circuits which are loads on the signal can be roughly characterized as a function which increases with both additional loads and also with additional distance between the source and the loads. For this reason, methods for optimizing the performance of a circuit design will typically undertake to minimize both the distance required to interconnect a source with all the required loads, and also the number of loads placed upon any signal source.

There are many methods of logic circuit synthesis, logic optimization, and logic placement which attempt to minimize gate count, logic net distance and overall circuit delay such that the overall performance of a circuit is maximized. Using these methods sometimes results in a design for which an overall solution is not readily apparent and the computer algorithms which choose and evaluate potential solutions do not converge on a solution which meets all of the requirements.

After a logic design has been implemented on an FPGA through any process of logic synthesis, logic optimization and logic placement an analysis of the timing characteristics can be performed and the results analyzed to identify critical timing paths which need further change or optimization of some kind to improve the timing of those paths. It can often be observed that the placement of logic involved in any one specific path could be improved, but the effect of moving logic to improve that path may prove significantly detrimental to the timing of other logic paths. The characteristic of the Xilinx Virtex FPGA which minimizes interdependencies between multiple loads on a source gate allows for an optimization of a specific path to be proposed which has minimal effect on other logic paths. This relatively easy to analyze improvement can be applied to only those paths which are most critical with respect to timing and because the changes have little impact on the timing of other paths it is more likely that the changes will achieve overall success. More specifically, the changes to improve one path will not be significantly detrimental to the performance of other paths so progress towards achieving overall good timing can be made.

The more specific method for making these final improvements in logic implementation and logic placement is to take a critical path and implement it using logic gates placed in along the shortest physical path with logic duplicated or moved as needed to achieve optimal implementation of that path. Any logic which is involved with other critical paths is replicated with the original logic left in place; any logic which is involved in only this specific critical path is simply moved. The only restriction on the logic implementation is that it must be fit into the existing layout of the circuit without significant detrimental effect on the placement of other logic. Since the exemplary Virtex chip provides interconnect and routing of signals from a source to a specific load in a manner such that the timing characteristic for that load that has been observed to be relatively independent of other loads, then the implementation of any one critical path can be reimplemented in a nearly optimal implementation with logic physically placed along a shortest Manhattan line while not having significant detrimental effect on other logic paths.

The process of implementing the logic, placing the logic, analyzing the performance and then re-implementing the logic and re-placing the logic for best performance by placing the critical logic along the shortest Manhattan line can be repeated until the most desirable results are achieved.

### BRIEF DESCRIPTION OF THE DRAWINGS

The present invention may be better understood, and its numerous objects, features, and advantages made apparent to those skilled in the art upon review of the following detailed description and by referencing the accompanying figures.
FIG. 1 depicts a simple logic circuit which will serve to illustrate the application of the invention;
FIG. 2 illustrates a trial layout plan for the gates from the circuit in FIG. 1 as might be determined by traditional methods;
FIG. 3 illustrates the same circuit from FIG. 1 and FIG. 2 with a specific critical timing path highlighted;
FIG. 4 illustrates the same layout as shown in FIG. 3 with the layout depicted with gates represented using boxes placed on a grid in a manner similar to that seen in a floorplanning tool for FPGA layout planning, and with the critical timing path shown in FIG. 3 traced with arrows;
FIG. 5 illustrates a view of a new circuit with the same logical functionality as the circuit depicted in FIG. 1, but with the logic implementation modified to improve the timing of the critical path identified in FIG. 3;
FIG. 6 illustrates the circuit from FIG. 5 with the gates represented as boxes placed on a grid in a manner similar to that used in FPGA layout planning and with the critical timing path shown in FIG. 5 traced with arrows;
FIG. 7 is a flow diagram showing the basic steps for improving the timing of a logic circuit as it might be implemented on an FPGA using methods in accordance with the present invention;
FIG. 8 illustrates the circuit of FIG. 6 with added notation showing locations of the FPGA used for other logic not part of the logic paths used for this illustration;
FIG. 9 illustrates logic placed along a shortest Manhattan line for minimal total routing distance in a critical logic path.

### DETAILED DESCRIPTION OF THE INVENTION

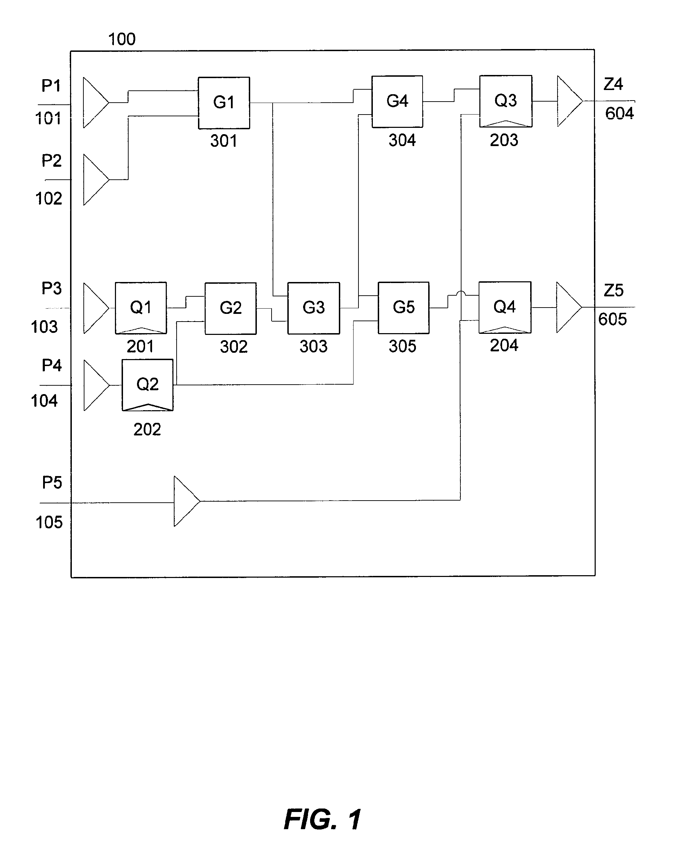

FIG. 1 depicts a simple logic circuit which will serve to illustrate the application of the invention. According to FIG. 1 the outer box (100), represents the outer boundary of an FPGA chip, or alternatively, a major region within the chip. External signals P1 - P5 (101-105) are inputs to a logic network contained within the box (100), and feed into the logic network consisting of gates G1 - G5 (301-305), input flip-flops Q1 (201) and Q2 (202), and output flip-flops Q3 (203) and Q4 (204). Outputs from the logic circuit are labeled Z4 (604) and Z5 (605).

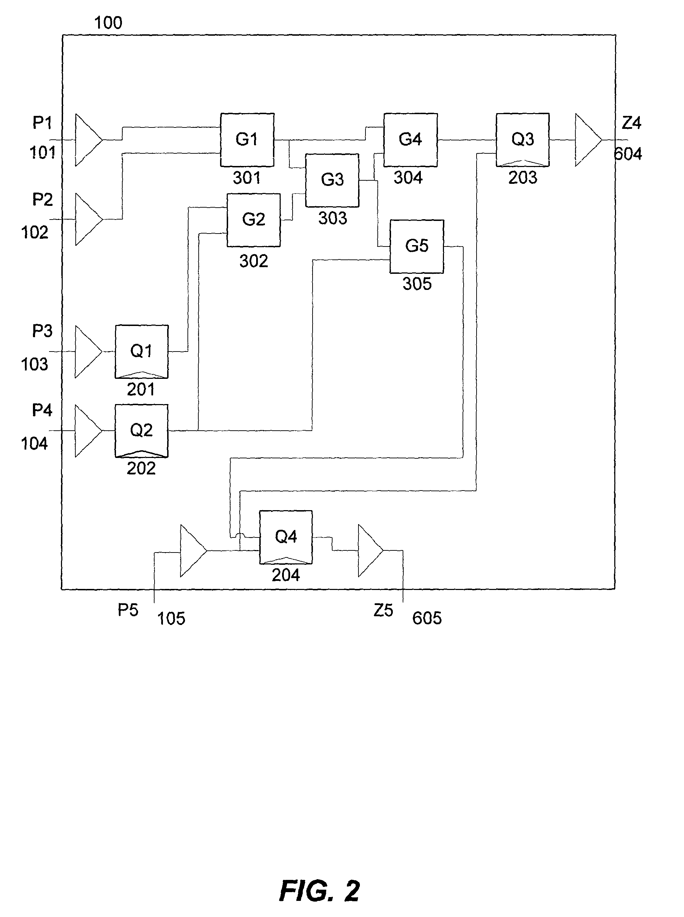

FIG. 2 illustrates a trial layout plan for the gates from the circuit in FIG. 1. The logic circuit of FIG. 2 is the same as FIG. 1 except in FIG. 2 the arrangement and placement of the logic circuitry depicts a rough planning layout that might be proposed by a logic designer. Input pins P1-P4 (101-104) are placed along the left edge of the box; input pin P5 (105) and output pin Z5 (605) are placed along the bottom side of the box. Pin Z4 (604) is placed at the upper end of the right side of the box. The logic within the box is placed so that related signals are moved closer together, and so that the logic flows smoothly from input pins to output pins.

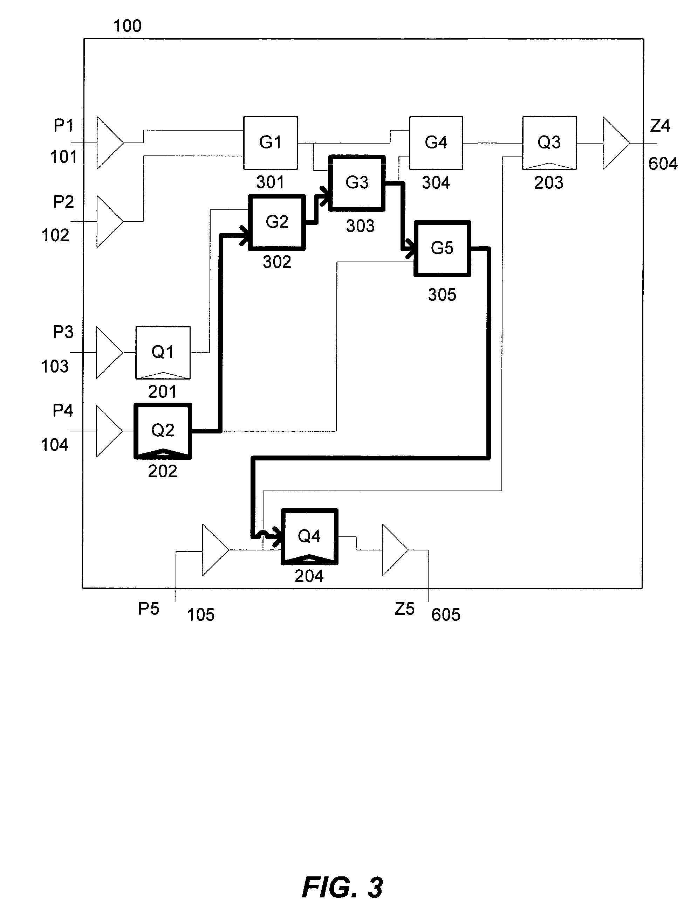

FIG. 3 illustrates the same circuit from FIG. 1 and FIG. 2 with a specific critical timing path (820) highlighted. The critical timing path depicted flows from flip-flop Q2, through gates G2, G3, and G5, and then into the data input of flip-flop Q4.

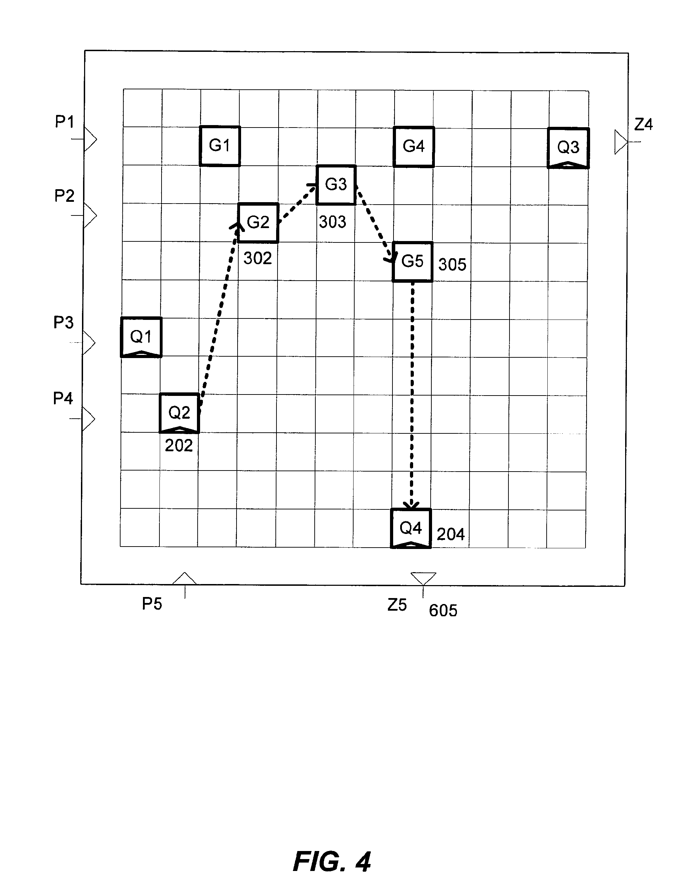

FIG. 4 illustrates the same circuit and layout as shown in FIG. 3 with layout of these same gates depicted using boxes placed on a grid in a manner similar to that seen in a floorplanning tool for FPGA layout planning, and with the same critical timing path (810) shown in FIG. 3 traced with arrows.

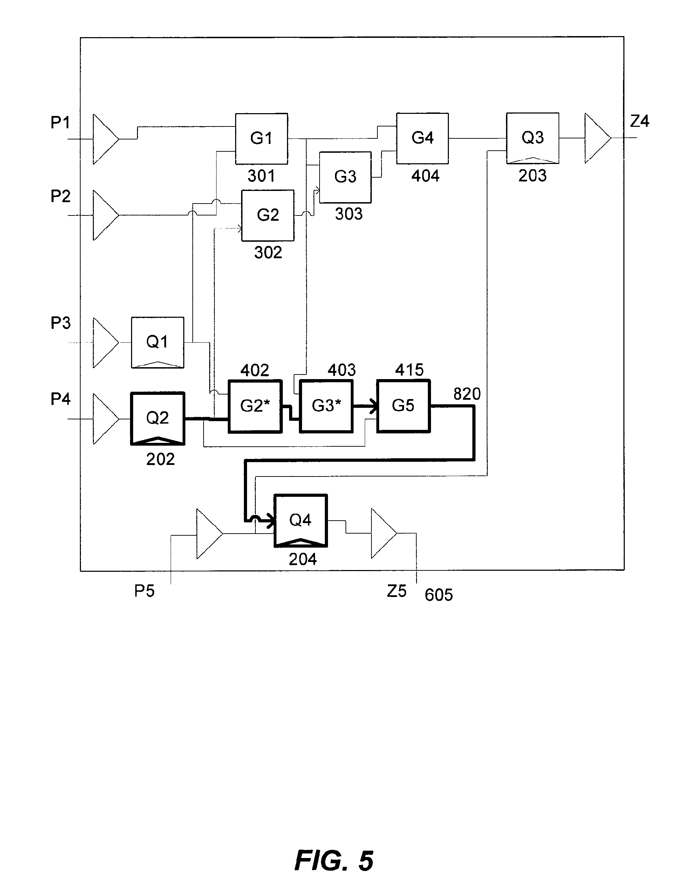

FIG. 5 illustrates a view of a alternate implementation with the same logical functionality as the circuit depicted in FIGS. 1-4, but with the logic implementation modified to improve the timing of the critical path (820) depicted in FIG. 3. In order to improve the timing of the critical path (820) without significant impact on other timing paths gates G1, G2, G3, and G4 (301-304) are left unchanged from the original circuit, new gates G2* (402), G3* (403) are added as duplicates of gates G2 (302) and G3 (303) respectively and connected in a manner such that the logic leading towards flip-flops Q3 (203) and Q4 (204) can be logically implemented and physically placed independently of each other. FIG. 5 illustrates the formation of the logical equations.

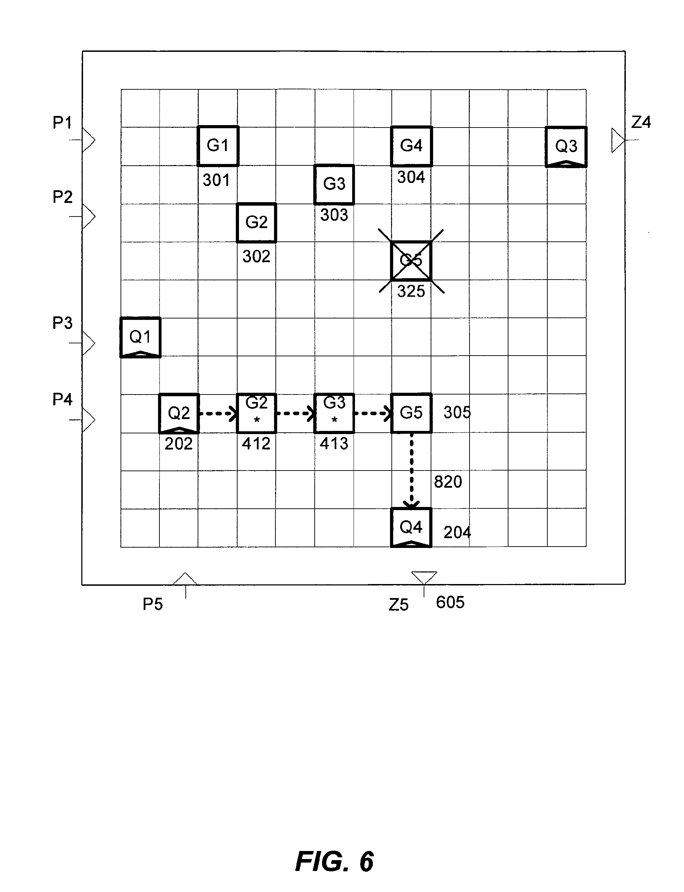

FIG. 6 illustrates the physical placement of the gates from FIG. 5 with the critical path (820) now leading directly in a Manhattan straight line towards flip-flop Q4 (204) while the implementation of the logic leading into flip-flop Q3 (203) remaining as originally implemented and placed. The physical distance covered by the new implementation and placement of the logic in the critical path (820) is shorter and thus faster than the original implementation.

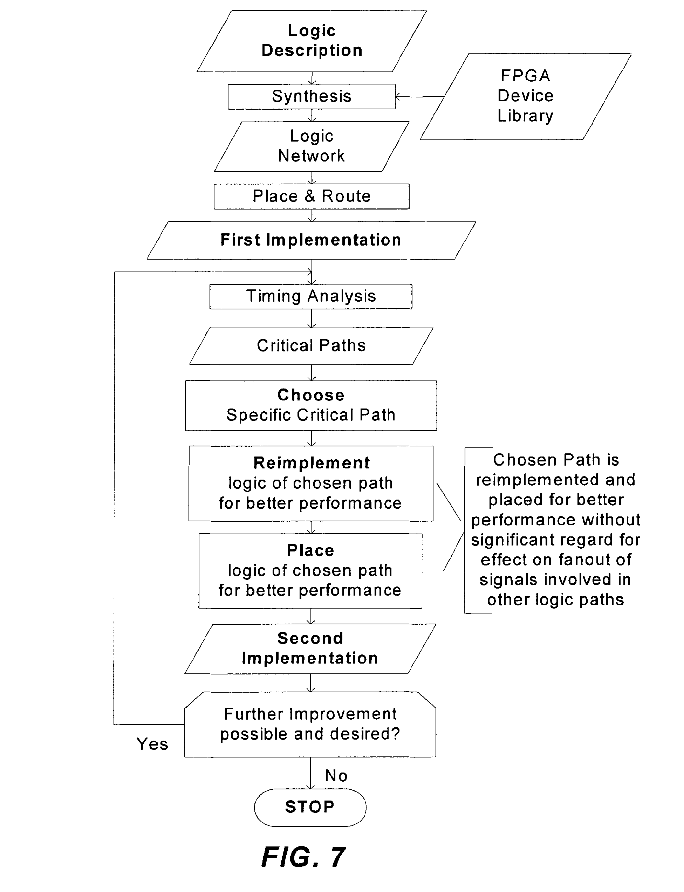

FIG. 7 is a flow diagram showing the basic steps for improving the timing of a logic circuit as it might be implemented on an FPGA using methods in accordance with the present invention.

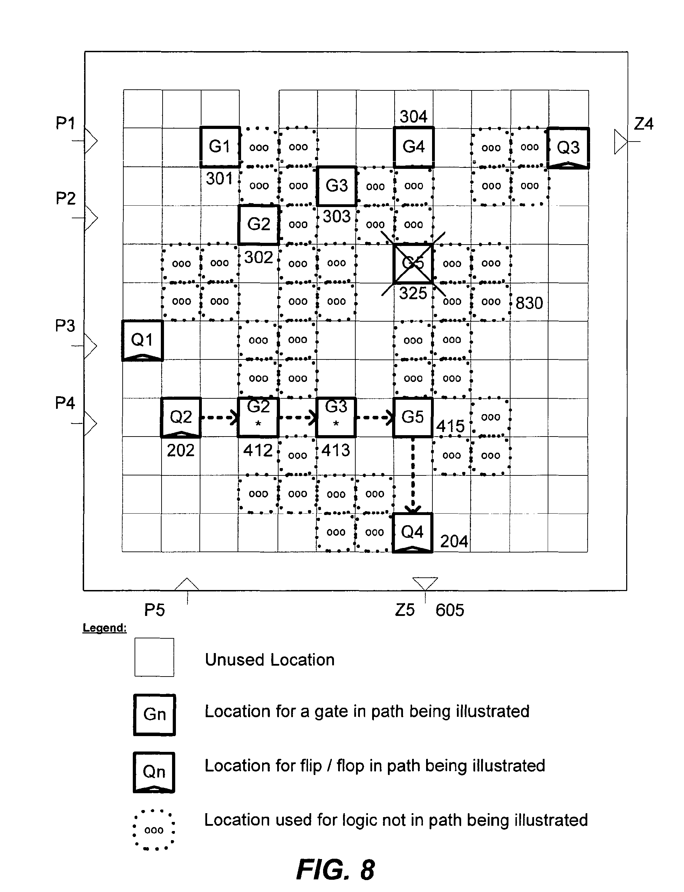

FIG. 8 illustrates the circuit of FIG. 6 with other logic (830) depicted which is not associated with the logic being currently improved and not part of the logic paths used for this illustration.

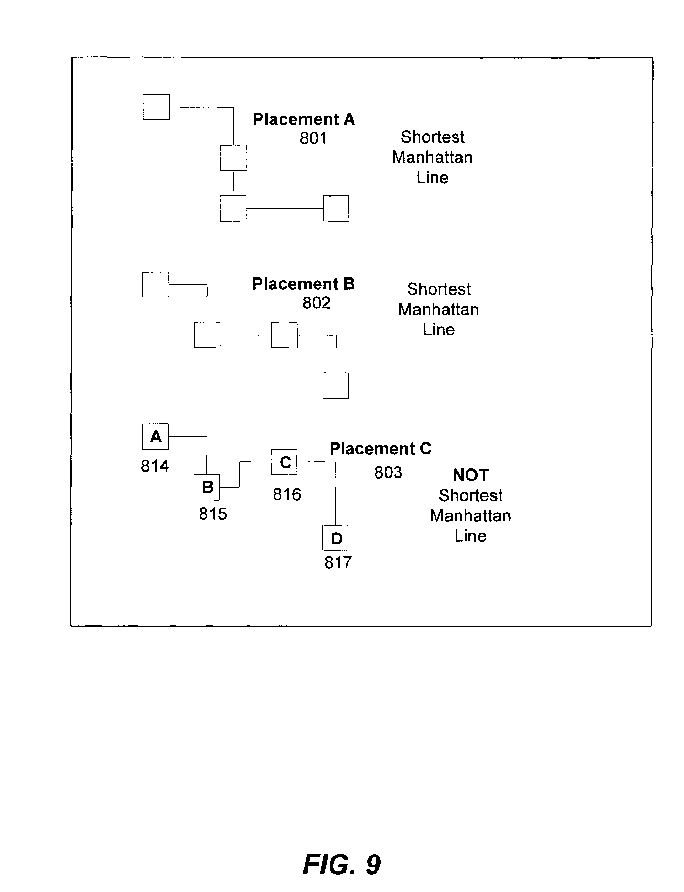

FIG. 9 illustrates logic placed along a shortest Manhattan line for minimal total routing distance in a critical logic path, where for purposes of lexicography, the words "shortest Manhattan line" as used throughout this application for patent are defined to mean a physical path between two points which connects the points using line segments which proceed along any routing path which would form approximately the shortest routed path between those two points. In FIG. 9 three placements of the same logic are depicted. Placement A (801) depicts logic placed along a path which is a shortest Manhattan line. Placement B (802) is an alternate placement along another shortest Manhattan line. Placement C **803** is another placement which is not along a shortest Manhattan line, and therefore would be expected to be less performant in consideration of timing. Specifcally in placement C (803) the second line segment (813) along the path between gate B (815) and gate C (816) does not proceed along the shortest Manhattan line from gate A (814) to gate D (817) because it jogs upward away from the final destination gate D (817) rather than proceeding in a direction of progress towards the destination.

The present invention provides a method for optimizing the logic implementation and layout for multiple logic paths in a Field Programmable Gate Array in a manner that allows each specific path to be optimized independently with little significant effect on other logic paths, and thus to achieve a high degree of optimization on several of the most critical paths with less iteration and difficulty in converging on a solution than methodologies of the prior art and thus to find and evaluate implementations of the overall circuit with better performance than might be achieved by methods of the prior art.

In most implementations of electronic circuits the logic delay from one circuit that is the source of a signal to those circuits which are loads on the signal can be roughly characterized as a function which increases with both additional loads and also with additional distance between the source and the loads. Oftentimes the delay function is complicated by issues such as signal reflection but those experienced in the art will recognize that in general adding either load or distance (or both) is likely to increases delay. For this reason, methods for optimizing the performance of a circuit design will typically undertake to minimize both the number of loads placed upon any signal source and also the distance required to interconnect a source with all the required loads. Typically, loading is minimized and balanced by some method of logic synthesis and logic optimization which reduces the total number of gates, and distance is minimized by a method which tries to place the individual gates which implement the synthesized circuits such that both the length of individual nets and also the overall total length of all nets is minimized.

There are many methods of logic circuit synthesis, logic optimization, and logic placement which attempt to minimize gate count, logic net distance and overall circuit delay such that the overall performance of a circuit is maximized. Using these methods sometimes results in a design for which an overall solution is not readily apparent and the computer algorithms which choose and evaluate potential solutions do not converge on a solution which meets all of the requirements. This failure to find a solution often happens because the interaction between logic paths presents a situation where changing the implementation of logic to improve one critical timing path adversely impacts the timing of another path either by changing the loading of signals in the other path, or by adversely affecting the placement of circuits involved in the other path. The detrimental effects can be either caused directly by moving or changing circuits in both paths or indirectly by logic changes which impact the other circuit by forcing such things as a change in placement or a change in the routing of signals that pass through the same areas of logic. These effects are often difficult to analyze or predict.

In some FPGAs, as exemplified by the Virtex family of FPGAs from Xilinx, it has been observed that the devices have a delay characteristic in which the delay from a source gate to any load gate is relatively independent of the fanout to other loads on the same net. That is, for a net which connects a source gate to multiple loads, the delay function for any given load is a function mainly of the distance from the source to that load with the effect of other loads on that delay being relatively small. This includes the effect of both the electrical loading and the electrical distance involved. The appreciation of this characteristic provides basis for a methodology providing an improved method of logic optimization. The implementation for interconnect on the exemplary Xilinx Virtex devices for which this characteristic has been observed has been described as follows by Xilinx: *"Xilinx Active Interconnect technology, built on the strength of the fourth generation segmented routing technology, provides full buffering at each routing interconnect point. This eliminates the variable routing delay effects* *of conventional interconnect architectures, where the total routing delay depends on the fan-out. With the conventional interconnect architecture, the routing delay of* a *particular node may be changed during design iteration, which makes complex designs like the ten million-system gates design impractical. In contrast, Active Interconnect technology allows precise delay calculations that are generally independent of signal fan-out.*"

After a logic design has been implemented on an FPGA through any process of logic synthesis, logic optimization and logic placement an analysis of the timing characteristics can be performed and the results analyzed to identify critical timing paths which need further change or optimization of some kind to improve the timing of those paths. It can often be observed that the placement of logic involved in any one specific path could be improved, but the effect of moving logic to improve that path may prove significantly detrimental to the timing of other logic paths. The characteristic of the Xilinx Virtex FPGA which minimizes interdependencies between multiple loads on a source gate allows for an optimization of a specific path to be proposed which has minimal effect on other logic paths. This improvement is relatively easy to analyze and can be applied to only those paths which are most critical with respect to timing and since the changes have little impact on the timing of other paths it is more likely that the changes will achieve overall success. That is, the changes to improve one path will not be significantly detrimental to the performance of other paths so progress towards achieving overall good timing can be made.

The more specific method for making these final improvements in logic implementation and logic placement is to take a critical path and implement it using logic gates placed in along the shortest physical path with logic duplicated or moved as needed to achieve optimal implementation of that path. Any logic which is involved with other critical paths is replicated; any logic which is involved in only this specific critical path is simply moved. The only restriction on the logic implementation is that it must be fit into the existing layout of the circuit without too much detrimental effect on the placement of other logic. Since the exemplary Virtex chip provides interconnect and routing of signals from a source to a specific load in a manner such that the timing characteristic for that load that has been observed to be relatively independent of other loads, then the implementation of any one critical path can be implemented with an optimal implementation with logic physically placed along a shortest Manhattan line while not having too much detrimental effect on other logic paths.

There are limits on the number of paths to which this broad optimization method can be applied since it is likely that the amount of logic required for the optimal implementation with respect to timing will be larger than the originally proposed implementation.

A specific embodiment of the invention is to synthesize a first logic implementation and then carry out an initial placement of the gates of the implementation using any method of the prior art. Then, using that initial placement as a base, analyze the critical timing paths and depict the logic involved in any specific critical path on a floorplan. The layout of the interconnect of the logic gates for this specific path can then be observed, and then modified to improve the performance of that specific path using one of the two following possibilities: 1) any logic gate in the path that is a source for signals involved in another critical path is replicated and then placed as close as possible to a location along the shortest Manhattan line along the desired physical path, or 2) any logic gate which is not connected to other critical paths is simply moved to a more desirable location, that is, a location as near as possible to an implementation lying along the shortest Manhattan distance from the beginning of the logic path to the end.

The process of implementing the logic, placing the logic, analyzing the performance and then re-implementing the logic and re-placing the logic for best performance by placing the critical logic along the shortest Manhattan line can be repeated until the most desirable results are achieved.

The improvement in timing of a logic circuit through duplication of logic and improved placement of that logic is typically encumbered by added delay in the overall implementation due to the additional electrical loading placed upon the gates driving the duplicated circuitry. In FIG. 5 this added loading can be observed on flip-flop Q2 (202) in that gate G2* (402) is an added loaded not present in the original circuit. The same gate G2* (402) is also an additional load on flip-flop Q1 (201).

This characteristic of delay in FPGA's, which is mostly independent of fanout, allows for a process for improving the timing of critical logical paths using duplication and more optimal placement of the logic involved in that path, without substantial detrimental impact due to electrical loading on either the path being optimized, nor on other circuitry not related to the path being improved. Typically the degree of application of this method is limited only by the space or room provided on the FPGA with the limit on the space used occurring when the duplicate logic begins to significantly impact the placement of other critical or nearly critical logic circuitry.

The foregoing description is meant to be illustrative only and not limiting. Other embodiments of this invention will be obvious to those skilled in the art in view of this description. Therefore, the spirit and scope of the appended claims should not be limited to the description of the preferred embodiments contained herein.

## Claims

1. A method for optimizing the timing performance of an overall logic circuit where that overall logic circuit is implemented in a Field Programmable Gate Array (FPGA) with programmable interconnect of the FPGA behaving in a way such that the timing of logic signals routed by the programmable interconnect from a specific source to a specific load within the FPGA is affected negligibly by fanout to other logic ioads connected to the same source signal, the method comprising the steps of:
a) synthesizing the overall logic for first implementation in an FPGA, the synthesis including construction and first placement of the logic functions on the FPGA,
b) analyzing the timing of the first implementation with the first placement,
c) determining the most critical timing paths from analysis of the first implementation,
d) selecting as an object for improvement a specific critical path from the most critical timing paths,
e) implementing in another way the critical logic in the chosen critical path with implementation of the critical logic performed with relative disregard as to the fanout of signals to other logic in the overall logic circuit and with placement of logic in the chosen critical path designed primarily to minimize the interconnected routing distance of the signals contributing to that chosen critical path.

2. The method of Claim 1 in which the implementation of the critical logic in a new way in step e) is limited only to changes in the placement of the logic in the chosen critical path.

3. A method for optimizing the timing performance of an overall logic circuit where that overall logic circuit is implemented in an FPGA with programmable interconnect of the FPGA behaving in a way such that the timing of logic signals routed by the programmable interconnect from a specific source to a specific load within the FPGA is affected negligibly by fanout to other logic loads connected to the same source signal, the method comprising the steps of:
a) synthesizing the overall logic for a base implementation in an FPGA, the synthesis including construction and placement of the logic functions on the FPGA,
b) analyzing the timing of the base implementation,
c) determining the most critical timing paths from analysis of the base implementation,
d) selecting as an object for improvement a chosen critical path from the most critical timing paths,
e) implementing in another way the critical logic in the chosen critical path with implementation of the critical logic performed with relative disregard as to the fanout of signals to other logic in the overall logic circuit and with placement of logic in the chosen critical path designed primarily to minimize the interconnected routing distance of the signals contributing to that chosen critical path,
f) modifying the placement of other logic in the overall logic circuit to accommodate the changes in placement of the chosen critical path while maintaining approximately the new placement of the critical logic,
g) repeating steps b) through f) where the last implementation and placement of the overall logic circuit from step f) becomes the basis for starting again with this last implementation becoming the base implementation.

4. The method of Claim 3 in which the implementation of the critical logic in a new way in step e) is limited only to changes in the placement of the logic in the chosen critical path.
